# EUROPEAN PATENT APPLICATION

(11) **EP 4 791 127 A1**
(43) Date of publication of application: **12.08.2026**
(21) Application number: 25156582.6
(22) Date of filing: 07.02.2025
(51) Int. Cl.: H05K 7/14

(54) **COMMUNICATION MODULE**

(71) Applicant: ifm electronic gmbh, 45128 Essen (DE)
(72) Inventor: Ryczaj, Wojciech, 45-831 Opole (PL); Durdyn, Andrzej, 12307 Berlin (DE); Durdyn, Jacek, 45-940 Opole (PL)
(74) Representative: Ifm Patentabteilung

(57) **Abstract**

A communication module for automation, comprising at least one board (1) and a housing (4, 5, 17) enclosing the board (1), characterized in that the board (1) comprises along a connection edge (111) of the board (1) on at least one of the upper surface (1a) and the lower surface (1b) of the board (1) at least one circuit path (2) for a direct connection with at least one direct printed circuit board (PCB) connector (6, 14), and the housing (4, 5, 17) encloses the board (1) in a way that allows the direct connection between the board (1) and the direct PCB connector (6, 14), and the direct PCB connector (6, 14) is designed in a way that one section of the direct PCB connector (6, 14) is an industry standard connection part (10) and the other is a direct PCB plug part (16) that can be inserted on the circuit path (2).

## Description

The present invention relates to a communication module and, more particularly, to communication modules for automation according to the preamble of claim 1.

Communication modules on the market such as masters, devices, splitters used for automation are composed of a PCB with connectors soldered to the PCB. The type and quantity of connectors are determined in the construction phase and will not be changed. The PCB with connectors is overmolded and its connector composition is non versatile. The user of that kind of module have to choose the module composition with a precise idea of which connectors they need and their quantity. The modules will comprise predetermined ports such as M12, M8, etc. Due to their design, they represent a significant material cost and the user cannot manage the choice of connectors during the use of that module. Current communication modules such as the one described in DE 10 2017 203 870 A1, are usually comprising a PCB on which are soldered components and connectors, then they are overmolded with one or two layers of plastic housing; in the present case there are two layers. Those communication modules have advantages for a general use, providing such advantages as IP65 to IP67 protection, being suitable for food industry or harsh environments but for some application it is not necessary, nonetheless the customers have to invest in a new communication module as often as their need changes for a specific connector configuration.

It is an object of the invention to provide a communication module for automation with direct connection, while avoiding the problems known from the prior art, where the ports can be chosen by the user, making the module versatile.

This object is achieved by the communication module according to claim 1.

Advantageous embodiments are specified in the further dependent claims.

In accordance with the present invention, there is provided a communication module for automation, comprising at least one board enclosed in a housing and characterized in that the board comprises along a connection edge of the board on at least one of the upper surface and/or the lower surface of the board at least one circuit path for a direct connection with at least one direct printed circuit board (PCB) connector. The housing encloses the board in a way that allows the direct connection between the board and the direct PCB connector. The direct PCB connector is designed in a way that one section of the direct PCB connector is an industry standard connection part (which could be for example, an M8 or M12 standard) and the other is a direct PCB plug part that can be inserted on the circuit path. A connection edge of the board could be in particular a side portion on an extremity of the board.

The upper surface of the board and/or the surface on the other side of the board which is the lower surface can, at least one of them or both of the, contain electronic components. The circuit path is a conductive layer allowing the connection between the board containing electronic components on it, and the connector. The direct PCB connector is a connector designed for the purpose of connecting it directly on the board.

The communication module for automation can be any kind of module used in automation, e.g. a master, device or passive splitter. It can comprise one (single-row) or more (multi-row) boards which are printed circuit boards (PCB).

The boards are maintained in the housing in a way which do not hinders the connections which is advantageous. Another advantage of this is that the circuit paths are preferably on an edge of the board: the connection edge. In that way all the electronic components soldered on the board are in a different zone than the zone where the connection happens e.i. connection edge, thus electronic components can be isolated from the connection edge as the housing encloses them, diminishing the impact of the environment on the zone of the board with electronic components. Using direct PCB connectors from the market is advantageous as it allows a wide choice of type of connectors. The use of direct PCB connection allows the versatility absent in current communication modules on the market and a possibility of choice of connection types for the customer.

In a preferred embodiment, the circuit path can be designed in a way that the connection with the direct PCB connector is made by spring connection, as the direct PCB plug part clips on the board through fastening openings with a complementary fastening system. The spring connection can be made, for example, through a tooth on a spring mechanism, just like a clip, engaging into the fastening opening in the board, which is a hole of the dimention of the tooth. The direct PCB plug part can be released through a release mechanism present on the direct PCB connector, which could be pressed and lift the tooth, in the same way that a clip works, enabling a fast and easy connection and release. The advantage of allowing the direct PCB connector to clip on the board is to provide a stable connection between the board and the connector.

In a preferred embodiment, the housing comprises a lower housing and an upper housing, where the lower housing is holding the board, in a way that a lower edge of the board is fixed on a bottom plane of the lower housing. A lower edge of the board could be in particular a side portion on an extremity of the board, preferably on the extremity of the board opposite to the extremity on which is situated the connection edge of the board. A bottom plane of the lower housing can be in particular a plane of the housing on the internal side of the housing, which is hidden when the housing is assembled. This housing configuration is advantageous by an easy and more economical manufacturing, compared to the housing of communication modules on the market. It allows an easy access to the board in case of maintenance, which is impossible for overmolded housings.

In another preferred embodiment, two boards are placed facing eachother and perpendicularly to the bottom plane of the lower housing, which constitutes an advantageous configuration as the connectors can easily be accessed when the communication module is fixed to a support, and the allignement of boards in this configuration allows a compact solution with a narrower housing.

In a preferred embodiment, two boards may be linked by a metal pin and/or a Flex Foil PCB connection, which are two possible, effective, and non expensive ways to connect two boards.

In a preferred embodiment, the upper housing comprises at least one connection port in a top plane of the upper housing through which connectors can be plugged in and connected to the circuit paths. The advantage of connection ports is to assure a correct plugging of the connector onto the circuit paths by leading the connector, and to define a distance between each connector.

As another preferred embodiment, at least one protection cap can be plugged into the connection port not in use, in order to protect it from the environment.

A preferred embodiment is that the housing is molded over the board by injection moulding process, preferably a high pressure injection moulding process. It can be one or several layers of molding, applied in particular by plastic injection molding. The advantage of this embodiment is that the part of the board with electronics soldered on it will be enclosed by the molded housing and isolated from the environment. This limits dust or other elements which are considered as having environmental impact on electronics. In that embodiment it is preferred, that the connection edge can be outside of the molded housing, leaving the circuit paths accessible for connection.

Another preferred embodiment is that the direct PCB plug part has a U-shape in a way that it adapts and attaches on the board, and makes contact with the circuit paths. This is advantageous by allowing a good positioning when the direct PCB connector is pushed onto the board in a connection purpose.

A preferred embodiment will concern the use of direct PCB connectors connected to those boards, such as direct PCB wire connector, which advantage is to directly connect sealed wires if desired. There can also be used PCB direct M12 connector or PCB direct M8 connector, which are industry standard connectors on adapters for PCB direct connection, such as M8 or M12. The advantage of those is to allow a connection with counterconnectors widely used in the industry such as M8 or M12, according to what the customer needs to connect.

In a preferred embodiment, the direct PCB connector is an angled connector. The different angle configuration allows to adapt the positioning of connectors on the communication module, in order to manage and optimize the connections in given space.

Preferably, the printed circuit paths can be coated with gold by electroplating. The advantages of electroplating are the increase of the service life of the connection, reducing the transition resistance and protecting against corrosion.

Preferably, the board is 1 mm to 2 mm thich, preferably 1.6mm thick, and at least one circuit path has a width of 1 mm to 2 mm, preferably 1.6mm, and a length of 5mm to 6 mm, preferably 5.5 mm. The advantage of it is that those dimensions allow the use of direct PCB connectors present on the market.

In a preferred embodiment, the communication module is using a communication standard, like IO-link protocol, to connect a sensor and/or actuator to a control unit. The advantage to this is that the communication module is adapted for standardized use in the industry and complies with industry requirements in the matter on industrial communication.

Advantages of this invention are versatility and enhancement of possibilities in the choice of connections, making it easily adaptable to the needs of the user.

Further information and embodiments will be disclosed in the following detailed description with appropriate reference to the accompanying drawings.

It shows schematically:
Fig. 1 pespective view of a communication module with direct PCB connectors and protective caps
Fig. 2 Side view of a communication module without upper housing and connectors, with a connector of type Rj45
Fig. 3 pespective view of a communication module with housing and connection cable
Fig. 4 pespective view of a communication module with housing, connectors and protective caps
Fig. 5 side view of a PCB Direct-M12 connector with direct PCB plug part and M12 standard connection part
Fig. 6 perspective view of a straight PCB Direct-M12 connector with direct PCB plug part and M12 standard connection part
Fig. 7 perspective view of an angled PCB Direct-M12 connector with direct PCB plug part and M12 standard connection part
Fig. 8 top view of a communication module without upper housing and connectors, with a connector of type Rj45, with two boards and a connection between boards
Fig. 9 pespective view of a communication module with a housing and Direct PCB connectors
Fig.10 pespective view of a communication module with a high-pressure overmolded housing
Fig.11 pespective view of a communication module with a high-pressure overmolded housing with cable and mounted connectors

In the following description of the preferred embodiments, identical reference signs denote identical or comparable components.

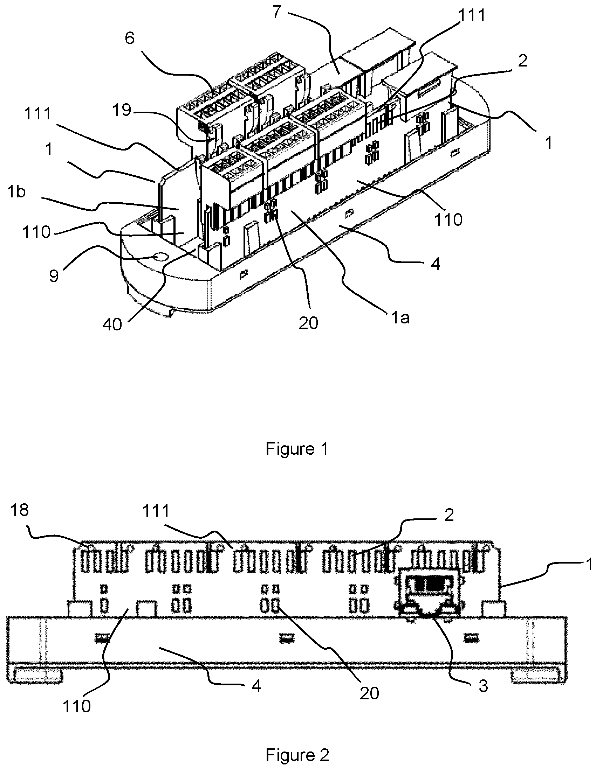

Referring to the drawings, as presented in figure 1, the communication module can have a lower housing 4 with a bottom plane 40 holding the boards 1 by a lower edge 110 of the boards 1, and several wire connectors 6 with PCB direct connection can be connected to the boards 1 through the circuit paths 2 situated on the connection edge 111 of the board 1, on any side of the board: the lower surface 1b as well as the upper surface 1a. This kind of connectors give even more freedom choosing the connection purpose: it allows implementing a communication connection and/or power supply. The circuit paths 2 which are not in use can be coverted by caps 7. Electronic components 20 can be soldered to the board 1 on the lower edge 110 of the board 1. The PCB direct connectors 6 can be released from the board by actioning the release mechanism 19. The communication module is preferably fixed to a support through mounting holes 9.

On figure 2 is represented a communication module for automation with a board 1 particularly having a connection with a standard Rj45 communication connector 3 which can replace a standard M12 D-Code connector used currently in master devices on the market. The board 1 having circuit paths 2, on the connection edge 111 of the board 1, suitable for direct connection, and fastening openings 18 allowing a PCB direct connector to clip into the board 1 when connected, and to secure the connection. The board 1 can be placed on a lower housing part 4 which serves as base for the board 1 and can be fixed to a support.

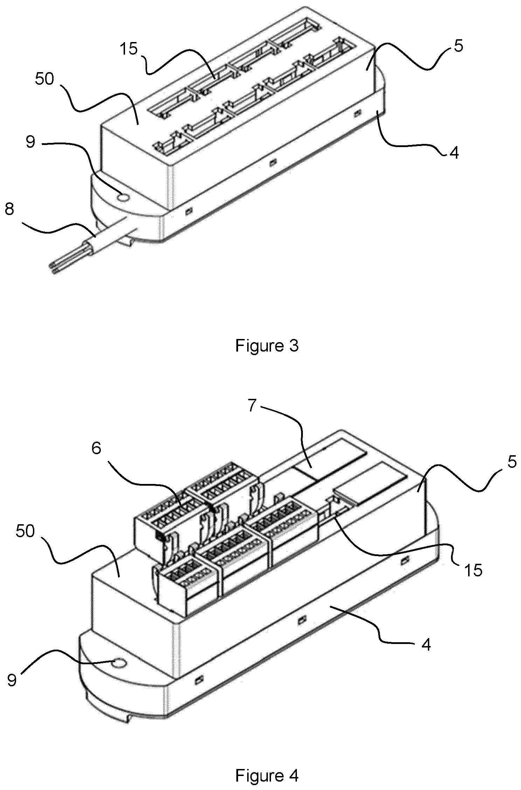

As represented in figure 3, the module can be composed of a two-parted housing, with a lower housing 4 which serves the purpose of holding the boards 1 in place and the upper housing 5 encloses the boards 1, and provides in a top plane 50 of the upper housing 5 connection ports 15 through which connectors can be plugged in and connected to the circuit paths 2 on the boards 1 under the upper housing part 5. The module can be connected to sensors through a connection cable 8. This gives the customer the freedom of adjusting the length of the cables from the sensor to the communication module on their own. The dimensions of the housing 4,5 allow the device to be mounted in the ifm E7800 Rail DIN mounting adapter. It is also possible to integrate a DIN rail holder directly into the lower housing 4 as a component of the lower housing 4 or fix the module to a support through mounting holes 9

Figure 4 shows the same module configuration as in the figure 1, but closed by the upper housing part 5. The connection ports 15 in the top plane 50 which are not in use, can be protected from environmental exposure by means of at least one cap 7.

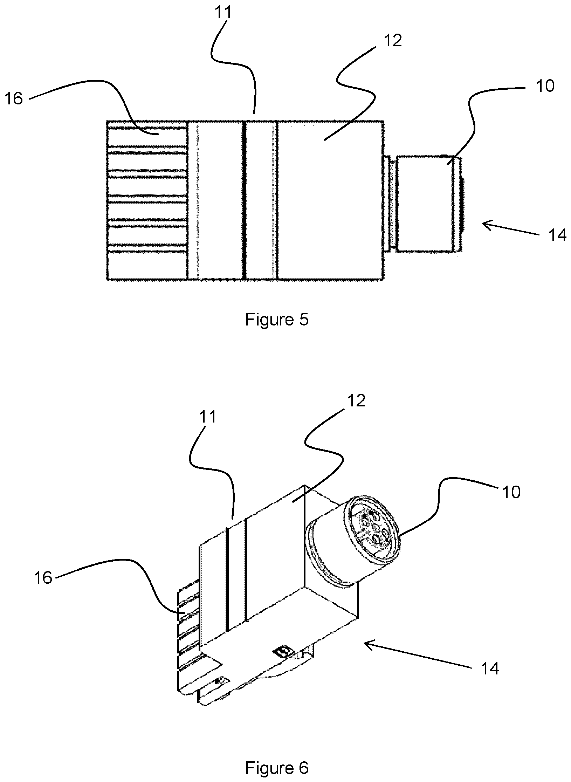

Figure 5 presents a PCB direct M12 connector 14 which is preferably composed of an industry standard connection part 10, which can be an M12 connector with M12x1 metal threaded sleeve, along with conductive contacts connected to the direct PCB plug part 16 with 0.34mm² wires, through an adapter 11. In order to ensure the strength of the connection, the whole is preferably covered with a plastic (e.g. TPU, PA) connector housing 12. It allows the user to connect on the communication module traditional cables with M12 or M8 connectors. Figure 5 is presenting an M12 connector with a PCB direct connection 14, but it could also be an M8 connector.

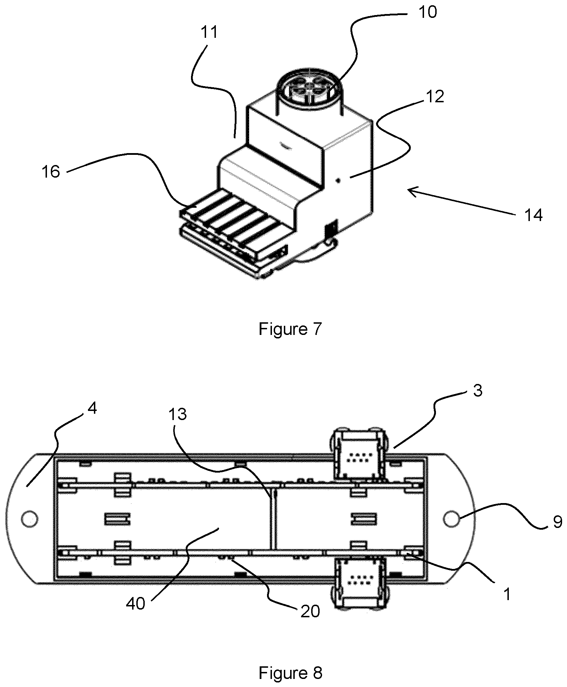

Figure 6 represents the connector described in figure 5 on a straight configuration. Figure 7 represents the connector described in figure 5 on an angled configuration.The different angle configuration allows to adapt the positioning of connectors on the communication module, in order to manage and optimize the connections in given space.

Is shown in figure 8, a multi-row communication module for automation, preferably with two boards 1, each board 1 can have a connection with one standard Rj45 communication connector 3 and electronic components 20, a connection can be made between several boards 1 using metal pins 13 or using a Flex Foil for PCB connection. The boards are preferably placed on the bottom plane 40 of the lower housing part 4, which can be fixed to a support through the two mounting holes 9.

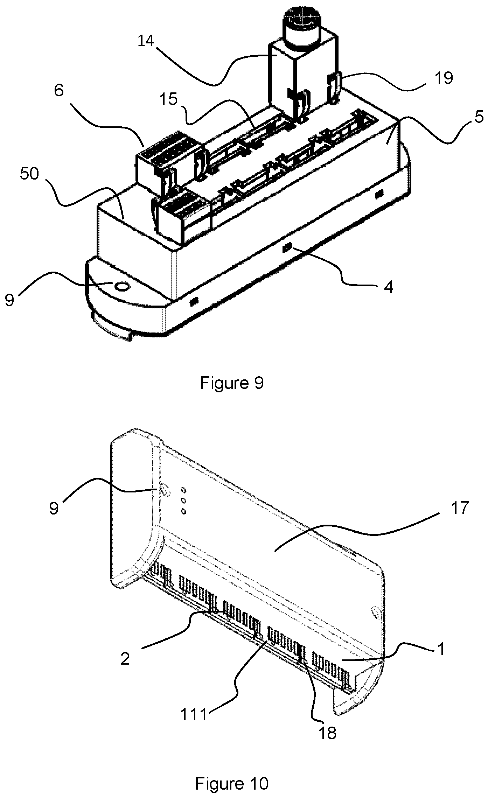

Figure 9 represents the module described in previous figures, preferably composed of the lower housing part 4 and the upper housing part 5. The direct PCB wire connectors 6 and the PCB direct M12 connector 14 can be connected through the connection ports 15 in the top plane 50 of the upper housing part 5, and can be released through the release mechanism 19.

Figure 10 represents another possible housing 17 of the communication module, which can be applied to the PCB by high pressure overmolding using a thermoplastic material (not limiting). There can be provided two mounting holes 9 in order to fix the module to a support using two M5 screws. The boards 1 are then permanently overmolded and the connection edge 111 of the board 1 being outside of the housing 17 leaves the circuit paths 2 accessible for connection.

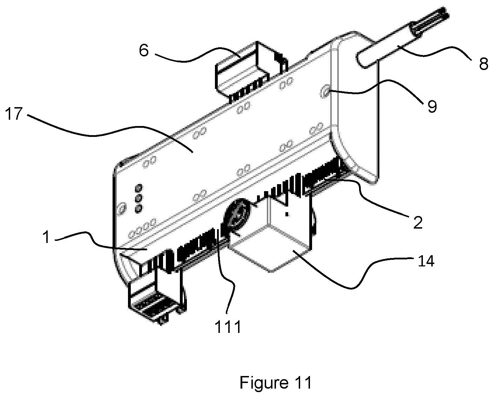

Figure 11 represents the module described in figure 10 with mounted connectors, in particular direct PCB wire connector 6 and angled PCB direct M12 connector 14, connected to the circuit paths 2 on the connection edge 111 of the board 1. This particular overmolded housing 17 can allow a PCB direct connection in another configuration and the presence of a connection cable 8. There can also be provided two mounting holes 9.

Fig. 1, fig.4, fig.9 and fig.11 present different connectors which can be connected to those boards 1 by direct connection, but the presented connectors are not limiting.

Combinations described in each drawing are not limited to masters, devices or splitters, any communication module can be built with listed elements.

### References:

- 1: board
- 1a: upper surface
- 1b: lower surface
- 2: circuit path
- 3: Rj45 standard communication connector
- 4: lower housing
- 5: upper housing
- 6: direct PCB wire connector
- 7: cap
- 8: connection cable
- 9: mounting hole
- 10: industry standard connection part
- 11: adapter
- 12: plastic connector housing
- 13: metal pin
- 14: PCB direct M12 connector
- 15: connection port
- 16: Direct PCB plug part
- 17: high pressure molded housing
- 18: fastening openings
- 19: release mechanism
- 20: electronic components
- 40: bottom plane
- 50: top plane
- 110: lower edge
- 111: connection edge

## Claims

1. A communication module for automation, comprising:
At least one board (1) and a housing (4, 5, 17) enclosing the board (1),
**characterized in that** the board (1) comprises along a connection edge (111) of the board (1) on at least one of an upper surface (1a) and/or a lower surface (1b) of the board (1) at least one circuit path (2) for a direct connection with at least one direct printed circuit board (PCB) connector (6, 14), and the housing (4, 5, 17) encloses the board (1) in a way that allows the direct connection between the board (1) and the direct PCB connector (6, 14),
and the direct PCB connector (6, 14) is designed in a way that one section of the direct PCB connector (6, 14) is an industry standard connection part (10) and the other is a direct PCB plug part (16) that can be inserted on the circuit path (2).

2. The communication module for automation according to claim 1, wherein the circuit path (2) is designed in a way that the connection with the direct PCB connector (6, 14) is made by spring connection, as the direct PCB plug part (16) clips on the board (1) through fastening openings (18) with a complementary fastening system.

3. The communication module for automation according to claim 1 or 2, wherein the housing (4, 5) comprises a lower housing (4) and an upper housing (5), wherein the lower housing (4) is holding the board (1) in a way that a lower edge (110) of the board (1) is fixed on a bottom plane (40) of the lower housing (4).

4. The communication module for automation according to claim 3, wherein two boards (1) are placed facing eachother and perpendicularly to the bottom plane (40) of the lower housing (4).

5. The communication module for automation according to claim 4, wherein the boards (1) are linked by a metal pin (13) or a Flex Foil PCB connection.

6. The communication module for automation according to claims 3 to 5, wherein the upper housing (5) comprises at least one connection port (15) in a top plane (50) of the upper housing (5) through which connectors (6, 14) can be plugged in and connected to the circuit paths (2).

7. The communication module for automation according to claim 6, wherein at least one protection cap (7) is plugged into the connection port (15) not in use, in order to protect it from the environment.

8. The communication module for automation according to claim 1 or 2, where the housing (17) is molded over the board (1) by an injection moulding process, in particular a high pressure injection molding process, wherein the connection edge (111) is outside the molded housing (17), leaving the at least one circuit path (2) accessible for connection.

9. The communication module for automation according to claims 1 to 8, wherein the direct PCB plug part (16) has a U-shape in a way that it adapts and attaches on the board (1), and makes contact with the circuit paths (2) .

10. The communication module for automation according to claims 1 to 9, wherein at least one direct PCB connector (6) is a direct PCB wire connector.

11. The communication module for automation according to claims 1 to 9, wherein at least one direct PCB connector (14) is an angled connector.

12. The communication module for automation according to claims 1 to 11,
wherein the circuit path (2) is coated with gold by electroplating.

13. The communication module for automation according to claims 1 to 12,
wherein the board (1) is 1 mm to 2 mm thick, preferably 1.6mm thick, and at least one circuit path (2) has a width of 1 mm to 2 mm, preferably 1.6mm, and a length of 5mm to 6 mm, preferably 5.5 mm.

14. The communication module for automation according to claims 1 to 13, where the communication module is using a communication standard, in particular IO-Link, to connect a sensor and/or actuator to a control unit.

## Amended claims

### Amended claims in accordance with Rule 137(2) EPC.

**1.** A communication module for automation, comprising:
At least one board (1)
comprising along a connection edge (111) of the board (1) on at least one of an upper surface (1a) and/or a lower surface (1b) of the board (1) at least one circuit path (2)
at least one direct printed circuit board (PCB) connector (6, 14), designed in a way that one section of the direct PCB connector (6, 14) is an industry standard connection part (10) and the other is a direct PCB plug part (16) that can be inserted on the circuit path (2), and
a housing (4, 5, 17) enclosing the board (1) in a way that allows the direct connection between the board (1) and the direct PCB connector (6, 14),
**characterized in that** the housing (4, 5, 17) is configured such that, when the direct PCB plug part (16) is connected to the board (1), the industry standard connection part (10) is located outside of the housing (4, 5, 17), allowing for the direct PCB connector to be attached or detached from the board without interference from the housing.

**2.** The communication module for automation according to claim 1, wherein the circuit path (2) is designed in a way that the connection with the direct PCB connector (6, 14) is made by spring connection, as the direct PCB plug part (16) clips on the board (1) through fastening openings (18) with a complementary fastening system.

**3.** The communication module for automation according to claim 1 or 2, wherein the housing (4, 5) comprises a lower housing (4) and an upper housing (5), wherein the lower housing (4) is holding the board (1) in a way that a lower edge (110) of the board (1) is fixed on a bottom plane (40) of the lower housing (4).

**4.** The communication module for automation according to claim 3, wherein two boards (1) are placed facing eachother and perpendicularly to the bottom plane (40) of the lower housing (4).

**5.** The communication module for automation according to claim 4, wherein the boards (1) are linked by a metal pin (13) or a Flex Foil PCB connection.

**6.** The communication module for automation according to claims 3 to 5, wherein the upper housing (5) comprises at least one connection port (15) in a top plane (50) of the upper housing (5) through which connectors (6, 14) can be plugged in and connected to the circuit paths (2).

**7.** The communication module for automation according to claim 6, wherein at least one protection cap (7) is plugged into the connection port (15) not in use, in order to protect it from the environment.

**8.** The communication module for automation according to claim 1 or 2, where the housing (17) is molded over the board (1) by an injection moulding process, in particular a high pressure injection molding process, wherein the connection edge (111) is outside the molded housing (17), leaving the at least one circuit path (2) accessible for connection.

**9.** The communication module for automation according to claims 1 to 8, wherein the direct PCB plug part (16) has a U-shape in a way that it adapts and attaches on the board (1), and makes contact with the circuit paths (2) .

**10.** The communication module for automation according to claims 1 to 9, wherein at least one direct PCB connector (6) is a direct PCB wire connector.

**11.** The communication module for automation according to claims 1 to 9, wherein at least one direct PCB connector (14) is an angled connector.

**12.** The communication module for automation according to claims 1 to 11, wherein the circuit path (2) is coated with gold by electroplating.

**13.** The communication module for automation according to claims 1 to 12, wherein the board (1) is 1 mm to 2 mm thick, preferably 1.6mm thick, and at least one circuit path (2) has a width of 1 mm to 2 mm, preferably 1.6mm, and a length of 5mm to 6 mm, preferably 5.5 mm.

**14.** The communication module for automation according to claims 1 to 13, where the communication module is using a communication standard, in particular IO-Link, to connect a sensor and/or actuator to a control unit.

**1.** A communication module for automation, comprising:
At least one board (1) comprising along a connection edge (111) of the board (1) on at least one of an upper surface (1a) and/or a lower surface (1b) of the board (1) at least one circuit path (2),
at least one direct printed circuit board (PCB) connector (6, 14), designed in a way that one section of the direct PCB connector (6, 14) is an industry standard connection part (10) and the other is a direct PCB plug part (16) that can be inserted on the circuit path (2), and
a housing (4, 5, 17) enclosing the board (1) in a way that allows the direct connection between the board (1) and the direct PCB connector (6, 14),
**characterized in that**
the direct PCB plug part (16) has a U-shape in a way that it adapts and attaches on the board (1), and makes contact with the circuit path (2);
the circuit path (2) is designed in a way that the connection with the direct PCB connector (6, 14) is made by spring connection, as the direct PCB plug part (16) clips on the board (1) through fastening openings (18) with a complementary fastening system; and
the industry standard connection part (10) is M8 or M12 standard.

**2.** The communication module for automation according to claim 1 or 2, wherein the housing (4, 5) comprises a lower housing (4) and an upper housing (5), wherein the lower housing (4) is holding the board (1) in a way that a lower edge (110) of the board (1) is fixed on a bottom plane (40) of the lower housing (4).

**3.** The communication module for automation according to claim 3, wherein two boards (1) are placed facing eachother and perpendicularly to the bottom plane (40) of the lower housing (4).

**4.** The communication module for automation according to claim 4, wherein the boards (1) are linked by a metal pin (13) or a Flex Foil PCB connection.

**5.** The communication module for automation according to claims 3 to 5, wherein the upper housing (5) comprises at least one connection port (15) in a top plane (50) of the upper housing (5) through which connectors (6, 14) can be plugged in and connected to the circuit paths (2).

**6.** The communication module for automation according to claim 6, wherein at least one protection cap (7) is plugged into the connection port (15) not in use, in order to protect it from the environment.

**7.** The communication module for automation according to claim 1 or 2, where the housing (17) is molded over the board (1) by an injection moulding process, in particular a high pressure injection molding process, wherein the connection edge (111) is outside the molded housing (17), leaving the at least one circuit path (2) accessible for connection.

**8.** The communication module for automation according to claims 1 to 9, wherein at least one direct PCB connector (14) is an angled connector.

**9.** The communication module for automation according to claims 1 to 11, wherein the circuit path (2) is coated with gold by electroplating.

**10.** The communication module for automation according to claims 1 to 12, wherein the board (1) is 1 mm to 2 mm thick, preferably 1.6mm thick, and at least one circuit path (2) has a width of 1 mm to 2 mm, preferably 1.6mm, and a length of 5mm to 6 mm, preferably 5.5 mm.

**11.** The communication module for automation according to claims 1 to 13, where the communication module is using a communication standard, in particular IO-Link, to connect a sensor and/or actuator to a control unit.
